(19) Europäisches Patentamt
European Patent Office
Office européen des brevets

(11) **EP 3 244 137 B1**

(12) **EUROPÄISCHE PATENTSCHRIFT**

(45) Veröffentlichungstag und Bekanntmachung des Hinweises auf die Patenterteilung:
**28.07.2021   Patentblatt 2021/30**

(51) Int Cl.:
*F25B 9/14* (2006.01)     *F25B 21/00* (2006.01)
*F25D 19/00* (2006.01)     *H01F 6/04* (2006.01)

(21) Anmeldenummer: **17169531.5**

(22) Anmeldetag: **04.05.2017**

(54) **KRYOSTATANORDNUNG**

CRYOSTAT ARRANGEMENT

DISPOSITIF CRYOSTATIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.05.2016   DE 102016208226**

(43) Veröffentlichungstag der Anmeldung:
**15.11.2017   Patentblatt 2017/46**

(73) Patentinhaber: **Bruker Switzerland AG
8117 Fällanden (CH)**

(72) Erfinder:
• **WIKUS, Patrick
8309 Nürensdorf (CH)**
• **HINDERER, Jörg
79761 Waldshut-Tiengen (DE)**

(74) Vertreter: **Kohler Schmid Möbus Patentanwälte
Partnerschaftsgesellschaft mbB
Gropiusplatz 10
70563 Stuttgart (DE)**

(56) Entgegenhaltungen:
**EP-A2- 1 818 628     DE-B4- 19 914 778
JP-A- 2002 106 999**

## Beschreibung

Die Erfindung betrifft eine Kryostatanordnung, die mittels eines Kryokühlers trocken, also ohne Bereitstellung oder Zufuhr von kryogenen Fluiden, auf einer kryogenen Betriebstemperatur gehalten werden kann, wobei in der Kryostatanordnung zumindest im Betrieb eine supraleitende Magnetanordnung sowie eine Wärmesenke-Einrichtung zur Verlängerung der Zeit bis zur Rückkehr der supraleitenden Magnetanordnung in den normalleitenden Zustand (="Time-to-Quench") bei Versagen der aktiven Kühlung vorhanden sind.

Eine solche Kryostatanordnung, die allerdings immer noch geringe Mengen an flüssigem Kryogen enthält, ist an sich bekannt, etwa aus EP 0 937 953 A1 oder aus DE199 14 778 B4.

DE 199 14 778 B4 offenbart eine Kryostatanordnung gemäß dem Oberbegriff des Anspruchs 1.

### Hintergrund der Erfindung

Das Einsatzgebiet der vorliegenden Erfindung bildet ein kryogenes System zur Kühlung eines supraleitenden Magnetspulensystems, wie es beispielsweise für Anwendungen der Magnetresonanzspektroskopie (=NMR) oder der Magnetresonanztomographie (=MRI) eingesetzt wird. Die Anwendbarkeit der Erfindung ist jedoch nicht auf dieses Gebiet beschränkt.

Supraleitende Magnete müssen auf kryogene Temperaturen gekühlt werden, um funktionsfähig zu sein. Viele Anwender bevorzugen dabei "kryogenfreie" Magnete, die zur Gänze auf den Einsatz von Kryogenen (z.B. flüssiges Helium und/oder flüssigen Stickstoff) verzichten, und die Betriebstemperatur ausschließlich mit sogenannten "Kryokühlern", also "trocken" aufrechterhalten. Typischerweise kommen hier Pulsrohr-, Stirling- oder Gifford-McMahonkühler zum Einsatz.

Der Nachteil eines solchen kryogenfreien Magnetsystems besteht in der teilweise sehr kurzen "Time-to-Quench". Bei einem Ausfall des Kryokühlers (üblicherweise bedingt durch einen Stromausfall, eine Unterbrechung in der Kühlwasserversorgung, oder einen mechanischen Defekt am Kompressor oder Kaltkopf) wärmt sich das Magnetsystem sehr schnell über die zulässige Betriebstemperatur auf und quencht. Das Magnetsystem ist dann für längere Zeit nicht mehr benutzbar, da es wieder abgekühlt und neu geladen werden muss.

Eine Möglichkeit, die "Time-to-Quench" zu verlängern, besteht darin, geringe Mengen eines Kryogens vorzusehen, dessen Verdampfungswärme die Temperatur des Magnets im Falle eines Kühlerausfalls konstant hält. Diese Technik wird üblicherweise als "Minimum Condensed Volume" bezeichnet. Nachteilig ist, dass auch der Einsatz geringer Mengen eines Kryogens strenggenommen nicht mehr kompatibel mit der Definition "cryogen-free" ist.

Außerdem muss ein System vorgesehen werden, um das Kryogen beim Abkühlen des Magnets kondensieren zu können. Ebenfalls nachteilig ist, dass -bedingt durch die begrenzte Anzahl praktisch einsetzbarer Kryogene- nur einige wenige Betriebstemperaturfenster möglich sind (z.B. ca. 2,5K - 4,5K für He, ca. 70K - 77K für LN2, etc).

### Spezifischer Stand der Technik

Nach der eingangs zitierten EP 0 937 953 A1 wird die "Time-to-Quench" verlängert, indem kleine Mengen eines Kryogens in einem dafür vorgesehenen Reservoir bevorratet werden. Die Spule selbst liegt innerhalb dieses Reservoirs. Gegenüber einem "gewöhnlichen" Heliumtank ist dieses Reservoir zwar deutlich kleiner ausgebildet, um die Kryogenmenge so klein wie möglich zu halten. Wirklich "trocken" im strengen Sinne ist diese Anordnung allerdings dennoch nicht.

Auch bei der Kryostatanordnung nach der-ebenfalls eingangs zitierten-DE 199 14 778 B4 wird die "Time-to-Quench" dadurch verlängert, dass kleine Mengen eines Kryogens in einem dafür vorgesehenen Reservoir bevorratet werden. Die Spule selbst liegt allerdings im Vakuum, und ist thermisch mit dem Reservoir verbunden.

DE 10 2014 218 773 A1: Auch diese Erfindung hat die Verlängerung der "Time-to-Quench" zum Ziel. Es wird dort allerdings ein gänzlich anderer Ansatz verfolgt: Anstatt die Wärmekapazität bzw. die zu Verfügung stehende Wärmekapazität zu erhöhen, wird bei einem Ausfall des aktiven Kühlers die thermische Kopplung zwischen Spule und Kühler reduziert.

### Aufgabe der Erfindung

Der vorliegenden Erfindung liegt demgegenüber die Aufgabe zugrunde, eine "trockene" Kryostatanordnung der eingangs beschriebenen Art mit einem supraleitenden Magnetspulensystem mit möglichst einfachen technischen Mitteln dahingehend zu verbessern, dass die oben diskutierten Nachteile bekannter gattungsgemäßer Anordnungen vermieden werden. Insbesondere soll die Kryostatanordnung wirklich "kryogenfrei" betreibbar sein und bei eventuellen Betriebsstörungen eine ausreichend lange "Time-to-Quench" ermöglichen.

### Kurze Beschreibung der Erfindung

Diese Aufgabe wird erfindungsgemäß auf ebenso überraschend einfache wie wirkungsvolle Weise sowie mit ohne Weiteres zur Verfügung stehenden technischen Mitteln dadurch gelöst, dass die Wärmesenke-Einrichtung magnetokalorisches Material enthält, und dass die Wärmesenke-Einrichtung thermisch leitend mit der supraleitenden Magnetanordnung und/oder mit Teilen der Kryostatanordnung verbunden ist, über welche Umgebungswärme auf die Magnetanordnung fließen kann.

Genaue Wirkungsweise der Erfindung und weitere Vorteile gegenüber dem Stand der Technik

Die vorliegende Erfindung schlägt also eine Kryostatanordnung vor, welche es ermöglicht, eine supraleitende Magnetanordnung wirklich "trocken" zu betreiben, also ohne Zufuhr von kryogenen Fluiden auf einer kryogenen Betriebstemperatur zu halten, und diese Betriebstemperatur auch im Falle des Versagen der aktiven Kühlung für eine signifikante Zeitdauer aufrechtzuerhalten (Verlängerung der "Time-to-Quench").

Eine Kryostatanordnung gemäß der Erfindung wird durch Anspruch 1 definiert.

Zur effektiven Verlängerung der "Time-to-Quench" macht sich die Erfindung den magnetokalorischen Effekt zunutze, durch den magnetokalorisches Material seiner Umgebung bei annähernd konstanter Temperatur Wärme entzieht, wenn es entmagnetisiert wird. Auch Varianten, bei welchen das Material nicht entmagnetisiert wird, sondern nur ein Magnetfeld angelegt wird, um die spezifische Wärme zu maximieren, sind von der vorliegenden Erfindung umfasst.

Der sogenannte magnetokalorische Effekt beschreibt die thermische Reaktion eines Systems auf eine Änderung des Magnetfelds. Magnetokalorische Materialen - z.B. paramagnetische Salze, einige Oxide und Fluoride seltener Erden oder sogenannte "Laves-Phasen" Materialen - werden unter anderem in magnetischen Kühlern (zum Beispiel in adiabatischen Entmagnetisierungs-Kryostaten) eingesetzt. Diese magnetokalorischen Materialien zeichnen sich dadurch aus, dass deren Entropie durch Anlegen eines Magnetfelds verändert werden kann.

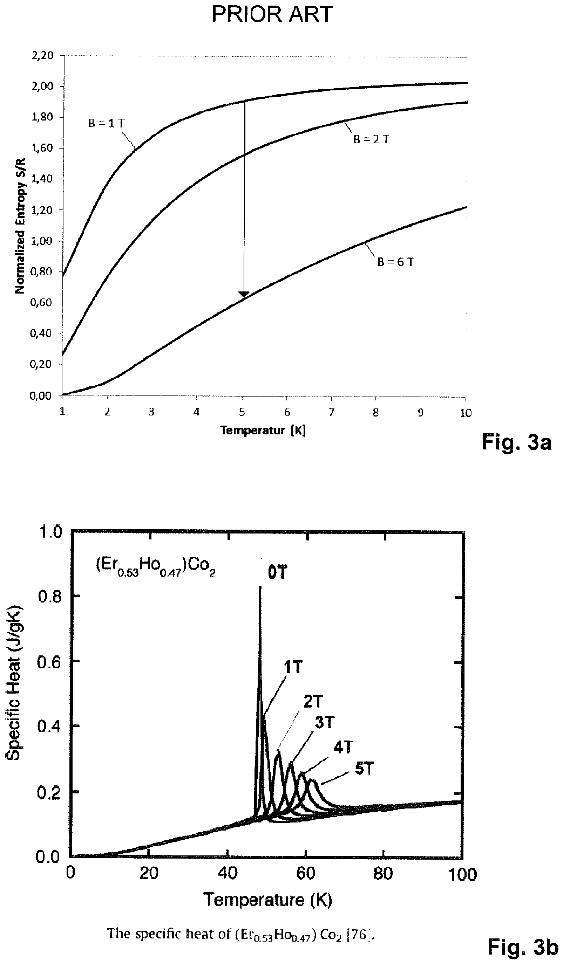

Beispielhaft ist in Fig. 3a ein Entropie-Temperaturdiagramm für das magnetokalorische Material GGG (Gadolinium Gallium Garnet) für drei verschiedene Magnetfelder (B = 1T, 2T und 6T) gezeigt. Die Entropie S wurde auf die ideale Gaskonstante R normiert.

Durch Anlegen eines Magnetfelds von 6T kann bei einer Temperatur von 5K die normierte Entropie S/R also auf einen Wert von etwa 0,62 gesenkt werden. Dies ist in der Abbildung durch den Pfeil angedeutet.

Findet in einem isothermen Prozess bei der Temperatur T eine Entropieveränderung ΔS statt, wird eine Wärmemenge Q entweder frei oder adsorbiert:

$$Q = T \cdot \Delta S$$

Wenn die Entropie gesenkt wird (d.h. bei der Magnetisierung des magnetokalorischen Materials), wird Wärme frei, bei der Demagnetisierung wird Wärme adsorbiert.

Diese Eigenschaft kann man sich erfindungsgemäß zu Nutze machen, um in einem kryogenfreien Magnetsystem mit einer supraleitenden Hauptspule die "Time-to-Quench" zu erhöhen. Dafür kann magnetokalorisches Material beispielsweise innerhalb einer supraleitenden Zusatzspule platziert werden.

Beim Abkühlen des Systems wird diese Zusatzspule geladen, die Entropie des magnetokalorischen Materials nimmt ab, und Wärme wird frei. Diese Wärme wird von einem Kryokühler abgeführt. Dann wird die Zusatzspule supraleitend kurzgeschlossen.

Wenn der Kryokühler ausfällt, wird die supraleitende Zusatzspule langsam entladen. Dabei absorbiert das magnetokalorische Material Wärme. Die Entladegeschwindigkeit kann so gewählt werden, dass die Rate, mit der Wärme im magnetokalorischen Material absorbiert wird, der Rate entspricht, mit der Wärme über die mechanische Trägerstruktur bzw. Stromzuleitungen oder Strahlung, sowie den ausgefallenen Kryokühler ins System fließt, d.h. die Hauptspule verändert ihre Temperatur nicht.

GGG hat eine Ionendichte von 1,26E22 cm-3. Für ein Volumen von einem Liter ergeben sich mit der idealen Gaskonstante R = 8,314J/(mol·K) bei einer Temperatur von 5K eine Entropie von 332J/K bei 1T, und eine Entropie von 109J/K bei 6T. Bei einer Temperatur von 5K können bei einer Entmagnetisierung von 6T auf 1T also 1115J absorbiert werden. Bei einer Wärmelast von 100mW = 0,1W verlängert das die "Time-to-Quench" um 11150 Sekunden oder um etwas mehr als drei Stunden.

Ein Volumen von einem Liter kann leicht untergebracht werden. Zum Vergleich: Das entspricht einem Zylinder mit einer Länge von 10cm und einem Durchmesser von etwa 12cm. Ein Liter flüssiges Helium würde bei der Verdampfung bei einer Temperatur von 4,2K etwa eine Wärmemenge von 2625J abführen. Helium hat also eine höhere volumetrische Effizienz, besonders, da bei der magnetokalorischen Wärmesenke noch das Volumen der Zusatzspule berücksichtigt werden muss.

Da viele Vorrichtungen, die für den Betrieb einer supraleitenden Magnetspule benötigt werden, in einem kryogenfreien Magneten in der Regel schon vorhanden sind (Isolationsvakuum, Stromzuführungen, etc), ist der Einbau einer solchen zusätzlichen Spule verhältnismäßig einfach zu realisieren.

Mögliche magnetokalorische Materialien sind: GGG (Gadolinium Gallium Garnet), Dysprosium Gallium Garnet (DGG), Gallium Lithium Fluorid (GLF), Dysprosium Aluminium Garnet (DAG), etc. Welches Material verwendet werden sollte, hängt stark von der Temperatur ab, bei der der Magnet betrieben wird.

Magnetokalorische Materialien weisen in gewissen Temperaturbereichen auch eine uncharakteristisch hohe spezifische Wärme auf. Diese Maxima der spezifischen Wärme können ebenfalls genutzt werden, um die "Time-to-Quench" zu verlängern:
In Fig. 3b ist die spezifische Wärme des magnetokalorischen Materials $(Er_{0.53}Ho_{0.47})Co_2$ gezeigt (aus: Zhu Y, Asamoto K, Nishimura Y, Kouen T, Abe S, Matsumoto K, et al. Cryogenics 2011;51:494).

Die vorliegende Erfindung kann auch dazu genutzt werden, die spezifische Wärme des magnetokalorischen Materials durch Anlegen eines Magnetfelds mit der Zusatzspule so zu verändern, dass sie ideal zur Betriebstemperatur des Magneten passt. Wird der Magnet z.B. bei 60K betrieben und würde (Er$_{0.53}$Ho$_{0.47}$)Co$_2$ als magnetokalorisches Material verwendet, könnte mit der Zusatzspule ein Feld von 4T - 5T angelegt werden. Die spezifische Wärme des magnetokalorischen Materials ist dann bei der Betriebstemperatur maximal, und im Falle eines Kühlerausfalls wird der Anstieg der Systemtemperatur verlangsamt.

Die hohe Wärmekapazität des magnetokalorischen Materials hat einen weiteren großen Vorteil, nämlich dass dynamische Fluktuationen (z.B. vom Kühler) abgedämpft werden.

Die oben beschrieben Zusatzspule muss so im Magnetsystem angebracht werden, dass das magnetokalorische Material möglichst magnetfeldfrei gemacht werden kann, um die mögliche Entropieänderung zu maximieren.

Das kann z.B. durch geeignete geometrische Positionierung erreicht werden (z.B. möglichst weit weg von der Hauptspule), oder indem ein magnetischer Schild aus z.B. Weicheisen oder einem supraleitenden Material vorgesehen wird. Des Weiteren ist es möglich, das Feld der Hauptspule durch Feldformspulen so zu formen, dass Bereiche mit niedriger Feldstärke entstehen.

Außerdem muss das magnetokalorische Material an einer Stelle angebracht sein, an der das Feld nicht zu groß ist, um zu vermeiden, dass das Material komplett gesättigt ist.

Im Wesentlichen gibt es hier die gleichen Lösungsmöglichkeiten wie bereits oben geschildert: Die Geometrie sollte entsprechend gewählt werden (z.B. weit weg), Einsatz magnetischer bzw. supraleitender Schilde, und Feldformspulen. Der Fachmann kennt diese Möglichkeiten. Es gibt auch recht nahe am Magneten Bereiche mit sehr niedriger Feldstärke. Zum Teil liegen die Feldnullstellen aufgrund der Abschirmung innerhalb der Hauptspule.

Durch geeignete Anordnung und/oder Abschirmung sollte die Feldveränderung, die sich durch Betätigen der Zusatzspule im Zentrum der Hauptspule ergibt, gering gehalten werden.

Auch hier sind die oben genannten Lösungen hilfreich. Es besteht nun allerdings auch die Möglichkeit, die magnetokalorische Einheit selbst aktiv abzuschirmen. Wenn die Zusatzspule als Solenoid ausgeführt ist, kann ein zweiter Solenoid außen um die Feldformeinheit gelegt werden, der gegenläufig stromdurchflossen ist und elektrisch in Serie mit der Zusatzspule geschaltet ist. Dadurch wird das Streufeld der Zusatzspule verkleinert. Dem Fachmann ist bekannt, wie das geht. Alternativ könnte die magnetokalorische Einheit als Ringkernspule ausgeführt werden. Ringkernspulen haben bauartbedingt ein geringes Streufeld.

Im Normalbetrieb muss die Temperatur des magnetokalorischen Materials konstant gehalten werden, damit sich keine Veränderung der Magnetisierung ergibt, die auf das Feld im Zentrum der Hauptspule wirken könnte. Technisch kann das z.B. so realisiert werden, dass die Temperatur des magnetokalorischen Materials ständig gemessen wird (etwa mit einem Widerstandsthermometer) und dann mittels einer PID Regeleinheit ein Heizer betrieben wird, der am magnetokalorischen Material angebracht ist. Eine andere Möglichkeit besteht darin, das magnetokalorische Material thermisch so gut zu isolieren (z.B. durch einen Strahlungsschild), dass das Material keinen Störeinflüssen wie beispielsweise einer variablen Wärmelast von außen ausgesetzt ist, und deshalb seine Temperatur nicht ändert. Dabei muss darauf geachtet werden, dass die magnetokalorische Einheit natürlich in gutem Kontakt mit der Spule oder mit den Aufhängeelementen, die sie im Falle eines PRK Ausfalls kühlen soll, sein muss.

Die Zusatzspule kann auch mit der Hauptspule kombiniert werden - entweder so, dass die Zusatzspule und die Hauptspule in Serie miteinander verschaltet sind, oder so, dass es überhaupt nur eine Spule gibt, und das magnetokalorische Material im Feld der Hauptspule angeordnet ist.

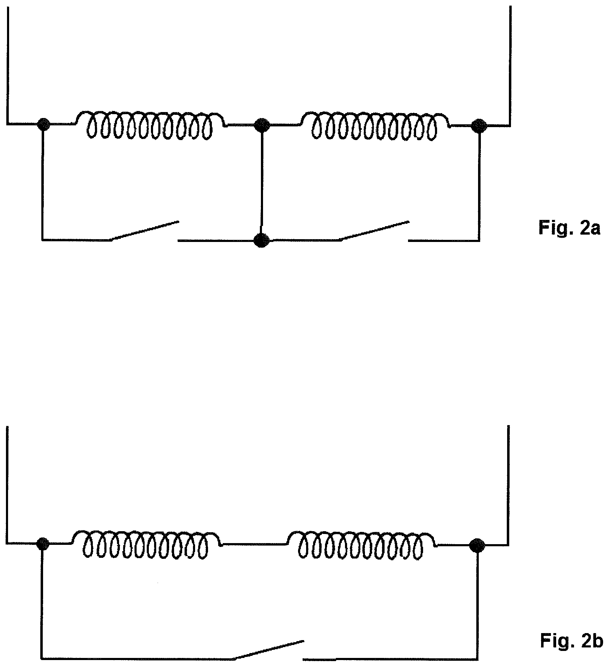

Wenn Zusatzspule und Hauptmagnetspule getrennt voneinander bestromt werden sollen, würde die Verschaltung etwa so aussehen, wie in Fig. 2a dargestellt.

Dabei ist besonders darauf zu achten, dass die Leistungsdissipation in den supraleitenden Schaltern bei deren Öffnung klein bleibt. Ein typischer Wert für die Leistungsdissipation in einem supraleitenden Schalter in kryogenfreien Magnetsystemen ist 10mW.

Um den Aufbau zu vereinfachen, könnte auf einen der beiden Schalter verzichtet werden, wie in Fig. 2b dargestellt:

Das Feld in der Hauptspule und in der Zusatzspule könnten dann nicht mehr unabhängig voneinander gewählt werden, d.h. bei einem Ausfall der aktiven Kühlung würde gleichzeitig mit der Zusatzspule auch gleich die Hauptspule entladen. Die oben gezeigte Verschaltung trifft auch zu, wenn es gar keine separate Spule für die magnetokalorische Einheit gibt, sondern wenn das magnetokalorische Material im Feld der Hauptspule positioniert wird.

Bevorzugte Ausführungsformen der Erfindung

Besonders bevorzugt sind Ausführungsformen der Erfindung, bei denen die Wärmesenke-Einrichtung thermisch leitend mit Teilen der Kryostatanordnung verbunden ist, über welche Umgebungswärme auf die Magnetanordnung fließen kann, und diese Teile innerhalb der Kryostatanordnung angeordnete Teile des Kryokühlers und/oder Strahlungsschilde und/oder mechanische Aufhängevorrichtungen für die Magnetanordnung und/oder elektrische Zuleitungen zur Magnetanordnung umfassen.

Die Wärmesenke wird üblicherweise direkt mit der Spule in thermischen Kontakt gebracht. Da in der Spule selbst aber keine Wärme dissipiert wird, reicht es aus, alle "Wärmepfade", die zur Spule führen, an die Wärmesenke anzukoppeln, und so Wärme, die entlang dieser Pfade fließt, abzufangen. Ein weiterer Vorteil besteht darin, dass die Wärmesenke bei höherer Temperatur betrieben werden kann, etwa wenn die Wärmesenke für 4K optimiert ist, der Magnet aber bei 3K betrieben wird. Dann kann die Wärmesenke mit einer thermisch schlecht leitenden Verbindung an die Spule angekoppelt werden, und einfließende Wärme direkt an den mechanischen Trägerstrukturen, etc. abfangen.

Vorteilhafte Weiterbildungen dieser Ausführungsformen sind dadurch gekennzeichnet, dass die Wärmesenke-Einrichtung in der Kryostatanordnung relativ zur supraleitenden Magnetanordnung derart angeordnet ist, dass das magnetokalorische Material möglichst magnetfeldfrei gemacht werden kann , so dass sich das magnetokalorische Material am Ende des Entmagnetisierungsprozesses in einem Feld < 2 Tesla befindet.

Die Wärmesenke absorbiert bei der Entmagnetisierung Wärme. Das Feld, bei dem der Entmagnetisierungsprozess endet, ist das Hintergrundfeld, das vom Hauptmagnet an der Stelle, an der die Wärmesenke sitzt, erzeugt wird. Je weiter die Wärmesenke entmagnetisiert werden kann, desto höher kann die Entropieänderung im magnetokalorischen Material sein, d.h. desto mehr Wärme kann absorbiert werden. Wenn das magnetokalorische Material komplett feldfrei ist, ist die Wärmeaufnahmekapazität bei gegebenem Startfeld am effizientesten.

In der Praxis bewähren sich auch Ausführungsformen der Erfindung, bei welchen eine Temperaturregeleinheit des magnetokalorischen Materials im Normalbetrieb vorhanden ist, die insbesondere ein Thermometer, eine Heizeinrichtung und eine elektronische Wärmeregeleinheit für die Wärmesenke-Einrichtung umfasst.

Die Magnetisierung des magnetokalorischen Materials ist temperaturabhängig. Wenn sich die Temperatur des Materials, und damit dessen Magnetisierung ändert, verändert sich das Magnetfeld im Probenvolumen, und die NMR Messung würde beeinflusst. Wenn es keine Temperaturstabilisierung gäbe, würde das magnetokalorische Material seine Temperatur ändern, wenn z.B. die Kühlleistung des Kryokühlers leicht schwankt.

Ganz besonders bevorzugt ist eine Klasse von Ausführungsformen der erfindungsgemäßen Kryostatanordnung, bei denen die Wärmesenke-Einrichtung mindestens eine -gegebenenfalls zusätzliche- Magnetspule umfasst.

Für die Entmagnetisierung des magnetokalorischen Materials muss das Magnetfeld am Ort der Wärmesenke verändert werden. Dies ist am einfachsten zu realisieren, wenn die Wärmesenke mit einer eigenen Spule ausgerüstet ist.

Wenn eine eigene Spule verwendet wird, ergibt sich auch die Möglichkeit, das Feld der Spule in der Wärmesenke unabhängig vom Feld des Hauptfeldmagneten zu verändern. Das ist von Vorteil, da im Falle eines Kühlerausfalls erst nur die Spule der Wärmesenke entladen werden kann, bevor der Hauptfeldmagnet "angefasst" werden muss.

Vorteilhafte Weiterbildungen dieser Klasse von Ausführungsformen sind dadurch gekennzeichnet, dass die Magnetspule der Wärmesenke-Einrichtung im Betriebszustand supraleitend kurzgeschlossen ist.

Dann muss kein Strom von einem externen Netzgerät in die Magnetspule eingespeist werden, was die Wärmelast auf das Gesamtsystem verringert (kein ohmsches Heizen in den Zuleitungen zur Magnetspule).

Andere vorteilhafte Weiterbildungen zeichnen sich dadurch aus, dass die Magnetspule der Wärmesenke-Einrichtung mit einer Spule der supraleitenden Magnetanordnung elektrisch verbunden ist.

Damit kann die gleiche Stromzuführung für den Hauptfeldmagnet und die Spule in der Wärmesenke verwendet werden, wodurch sich die Komplexität des Systems verringert, und auch die Wärmelast im Betrieb. Wie aus Fig. 2a zu sehen ist, sind dafür dann zwei supraleitende Schalter nötig.

Bei einer bevorzugten Klasse von Varianten ist die Magnetspule der Wärmesenke-Einrichtung mit einer Spule der supraleitenden Magnetanordnung elektrisch in Serie geschaltet.

Hier liegt der größte Vorteil in einer Verringerung der Systemkomplexität. Wie aus Fig. 2b zu sehen ist, kann auf diese Weise ein Schalter eingespart werden. Nachteilig ist, dass natürlich auch die Betriebsweise eingeschränkt ist, da die Wärmesenke nicht mehr unabhängig vom Hauptmagnet gesteuert werden kann.

Besonders kompakt sind Weiterbildungen, bei welchen die Magnetspule der Wärmesenke-Einrichtung und die Spule der supraleitenden Magnetanordnung räumlich so angeordnet und elektrisch derart miteinander verschaltet sind, dass sie gemeinsam eine magnetfelderzeugende Spule bilden.

Das ist die einfachste Anordnung, die die Komplexität so weit wie möglich verringert. Wenn der Kühler ausfällt, wird gleich der Hauptfeldmagnet entladen, und dadurch wird das magnetokalorische Material entmagnetisiert.

Vorteilhaft ist auch eine Klasse von Ausführungsformen der erfindungsgemäßen Kryostatanordnung, bei denen die Wärmesenke-Einrichtung, insbesondere eine Magnetspule in der Wärmesenke-Einrichtung, von einer magnetischen Abschirmung umgeben ist.

Das bringt gleich mehrere Vorteile: Zum einen ist das Minimalfeld, bis zu dem entmagnetisiert werden kann, kleiner als ohne Abschirmung, was eine erhöhte Effizienz bedeutet. Außerdem werden von der Wärmesenke verursachte Störungen im Probenvolumen -z.B. weil sich die Temperatur des magnetokalorischen Materials verändert, oder weil der Strom in der Spule der Wärmesenke verändert wird- am Ort des Probenvolumens abgeschwächt.

Eine erste vorteilhafte Weiterbildung dieser Klasse von Ausführungsformen ist dadurch gekennzeichnet, dass die magnetische Abschirmung der Wärmesenke-Einrichtung eine aktive Abschirm-Magnetspule umfasst.

Hier gelten die gleichen Vorteile wie oben diskutiert, hauptsächlich aber, dass Änderungen im Strom der Spule in der Wärmesenke nur eine kleine Veränderung des Magnetfelds außerhalb der Wärmesenke hervorrufen. Außerdem sind aktive Abschirmspulen besonders kompakt und effizient.

Alternativ kann aber bei einer anderen Weiterbildung die magnetische Abschirmung der Wärmesenke-Einrichtung eine passive Magnetschildanordnung, insbesondere aus supraleitendem Material, aus Weicheisen oder aus einer in sich kurzgeschlossenen Spule aus supraleitendem Draht, umfassen.

Eine solche Lösung ist besonders preiswert, technisch einfach zu realisieren, und ist sehr gut geeignet, Feldstörungen durch Temperaturänderungen des magnetokalorischen Materials zu unterdrücken.

Bevorzugt sind auch Ausführungsformen der erfindungsgemäßen Kryostatanordnung, sich dadurch auszeichnen, dass die supraleitende Magnetanordnung HTS-Elemente umfasst.

Der Vorteil beim Einsatz von HTS-Material liegt vor allem darin, dass sich entweder besonders hohe Felder erreichen lassen, oder der Magnet bei vergleichsweise hohen Temperaturen betrieben werden kann, was das Kühlsystem vereinfacht.

Ganz besonders bevorzugt sind auch Ausführungsformen der erfindungsgemäßen Kryostatanordnung, bei welchen die Kryostatanordnung Teil einer Magnetresonanz-Apparatur ist.

Schließlich ist es auch von erheblichem Vorteil, wenn die erfindungsgemäße Kryostatanordnung das magnetokalorische Material der Wärmesenke-Einrichtung GGG (=Gadolinium Gallium Garnet), DGG (=Dysprosium Gallium Garnet), GLF (=Gallium Lithium Fluorid") oder DAG (=Dysprosium Aluminium Garnet) enthält.

Detaillierte Beschreibung der Erfindung und Zeichnung

Die Erfindung ist in der Zeichnung dargestellt und wird anhand von Ausführungsbeispielen näher erläutert. Es zeigen:

Fig. 1     eine schematische vertikale Schnitt-Darstellung einer Ausführungsform der erfindungsgemäßen Kryostatanordnung;

Fig. 2a     ein elektrisches Schaltschema einer erfindungsgemäßen magnetokalorischen Zusatzspule parallel zur Hauptfeldspule der supraleitenden Magnetanordnung;

Fig. 2b     ein Schaltschema wie in Fig. 2a, jedoch mit elektrisch in Serie geschalteten Spulen;

Fig. 3a     ein Entropie-Temperaturdiagramm für das magnetokalorische Material GGG (Gadolinium Gallium Garnet) für drei verschiedene Magnetfelder (B = 1T, 2T und 6T), wobei die Entropie S auf die ideale Gaskonstante R normiert ist; und

Fig. 3b     die spezifische Wärme von magnetokalorischen Materials $(Er0.53Ho0.47)Co2$ als Funktion der Temperatur.

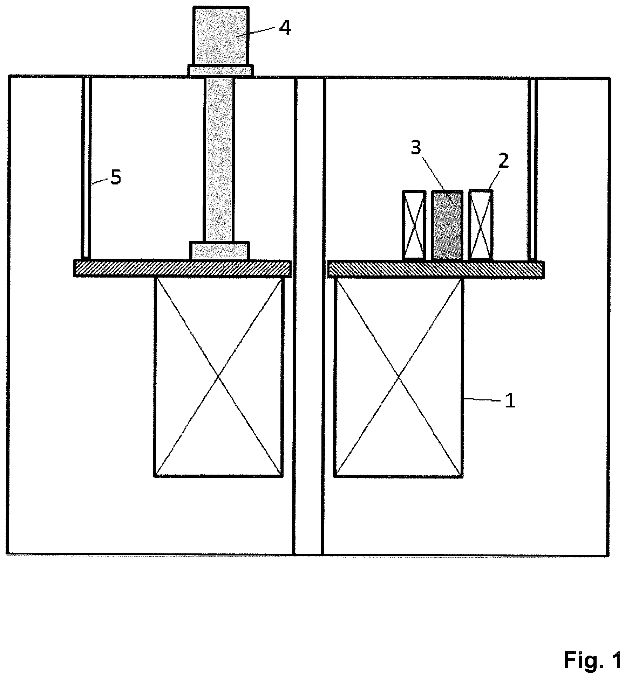

Die Figur 1 veranschaulicht sehr schematisch eine mögliche Ausführungsform der erfindungsgemäßen Kryostatanordnung. Diese kann mittels eines **Kryokühlers 4** trocken, also ohne Bereitstellung oder Zufuhr von kryogenen Fluiden, auf einer kryogenen Betriebstemperatur gehalten werden,. In der Kryostatanordnung sind zumindest im Betrieb eine **supraleitende Magnetanordnung 1** sowie eine Wärmesenke-Einrichtung zur Verlängerung der Zeit bis zur Rückkehr der supraleitenden Magnetanordnung 1 in den normalleitenden Zustand (="Time-to-Quench") bei Versagen der aktiven Kühlung vorhanden.

Erfindungsgemäß zeichnet sich die Kryostatanordnung dadurch aus, dass die Wärmesenke-Einrichtung **magnetokalorisches Material 3** enthält, und dass die Wärmesenke-Einrichtung thermisch leitend mit der supraleitenden Magnetanordnung 1 und/oder mit Teilen der Kryostatanordnung verbunden ist, über welche Umgebungswärme auf die Magnetanordnung 1 fließen kann.

Im dargestellten Ausführungsbeispiel umfasst die Wärmesenke-Einrichtung eine **zusätzliche Magnetspule 2.** Die Magnetspule 2 der Wärmesenke-Einrichtung kann im Betriebszustand supraleitend kurzgeschlossen und vorzugsweise mit einer Spule der supraleitenden Magnetanordnung 1 elektrisch verbunden sein, wie in den Figuren 2a und 2b gezeigt ist.

In Fig. 2b ist eine Variante der Erfindung dargestellt, bei welcher die Magnetspule 2 der Wärmesenke-Einrichtung mit einer Spule der supraleitenden Magnetanordnung 1 elektrisch in Serie geschaltet und räumlich so angeordnet, dass sie gemeinsam eine magnetfelderzeugende Spule bilden.

Diejenigen Teile der erfindungsgemäßen Kryostatanordnung, über welche Umgebungswärme auf die Magnetanordnung 1 fließen kann, umfassen innerhalb der Kryostatanordnung angeordnete Teile des Kryokühlers 4 und/oder Strahlungsschilde und/oder **mechanische Aufhängevorrichtungen 5** für die Magnetanordnung 1 und/oder elektrische Zuleitungen zur Magnetanordnung1.

Die Wärmesenke-Einrichtung in der Kryostatanordnung ist relativ zur supraleitenden Magnetanordnung 1 derart angeordnet, dass das magnetokalorische Material 3 auch im Betrieb möglichst magnetfeldfrei gemacht werden kann, so dass sich das magnetokalorische Material am Ende des Entmagnetisierungsprozesses in einem Feld < 2 Tesla befindet.

<u>Haupt-Anwendungsgebiet</u> der erfindungsgemäßen Kryostatanordnung ist der Einsatz in Magnetresonanzapparaturen.

**Bezugszeichenliste:**

1     supraleitende Magnetanordnung
2     zusätzliche Magnetspule
3     magnetokalorisches Material
4     Kryokühler
5     mechanische Aufhängevorrichtungen

**Patentansprüche**

1. Kryostatanordnung umfassend einen Kryokühler (4), mittels dessen die Kryostatanordnung trocken, also ohne Bereitstellung oder Zufuhr von kryogenen Fluiden, auf einer kryogenen Betriebstemperatur gehalten werden kann, wobei in der Kryostatanordnung zumindest eine supraleitende Magnetanordnung (1) sowie eine Wärmesenke-Einrichtung vorhanden sind, wobei die Wärmesenke-Einrichtung im Betrieb bei Versagen der aktiven Kühlung des Kryokühlers (4) die Zeit bis zur Rückkehr der supraleitenden Magnetanordnung (1) in den normalleitenden Zustand (="Time-to-Quench") verlängert, **dadurch gekennzeichnet,**
**dass** die Wärmesenke-Einrichtung magnetokalorisches Material (3) enthält,
und **dass** die Wärmesenke-Einrichtung thermisch leitend mit der supraleitenden Magnetanordnung (1) und/oder mit Teilen der Kryostatanordnung verbunden ist, über welche Umgebungswärme auf die Magnetanordnung (1) fließen kann.

2. Kryostatanordnung nach Anspruch 1, **dadurch gekennzeichnet, dass** die Teile der Kryostatanordnung, über welche Umgebungswärme auf die Magnetanordnung (1) fließen kann, innerhalb der Kryostatanordnung angeordnete Teile des Kryokühlers (4) und/oder andere Teile der Kryostatanordnung, nämlich Strahlungsschilde und/oder mechanische Aufhängevorrichtungen (5) für die Magnetanordnung (1) und/oder elektrische Zuleitungen zur Magnetanordnung (1) umfassen.

3. Kryostatanordnung nach Anspruch 1 oder 2, **dadurch gekennzeichnet, dass** die Wärmesenke-Einrichtung in der Kryostatanordnung relativ zur supraleitenden Magnetanordnung (1) derart angeordnet ist, dass das magnetokalorische Material (3) möglichst magnetfeldfrei gemacht werden kann, so dass sich das magnetokalorische Material am Ende des Entmagnetisierungsprozesses in einem Feld von < 2 Tesla befindet.

4. Kryostatanordnung nach einem der vorhergehenden Ansprüche, **dadurch gekennzeichnet, dass** eine Vorrichtung zur Konstanthaltung der Temperatur des magnetokalorischen Materials (3) im Normalbetrieb vorhanden ist, die insbesondere ein Thermometer, eine Heizeinrichtung und eine elektronische Wärmeregeleinheit für die Wärmesenke-Einrichtung umfasst.

5. Kryostatanordnung nach einem der vorhergehenden Ansprüche, **dadurch gekennzeichnet, dass** die Wärmesenke-Einrichtung mindestens eine -gegebenenfalls zusätzliche- Magnetspule (2) umfasst.

6. Kryostatanordnung nach Anspruch 5, **dadurch gekennzeichnet, dass** die Magnetspule (2) der Wärmesenke-Einrichtung im Betriebszustand supraleitend kurzgeschlossen ist

7. Kryostatanordnung nach Anspruch 5 oder 6, **dadurch gekennzeichnet, dass** die Magnetspule (2) der Wärmesenke-Einrichtung mit einer Spule der supraleitenden Magnetanordnung (1) elektrisch verbunden ist.

8. Kryostatanordnung nach Anspruch 7, **dadurch gekennzeichnet, dass** die Magnetspule (2) der Wärmesenke-Einrichtung mit einer Spule der supraleitenden Magnetanordnung (1) elektrisch in Serie geschaltet ist.

9. Kryostatanordnung nach Anspruch 8, **dadurch gekennzeichnet, dass** die Magnetspule (2) der Wärmesenke-Einrichtung und die Spule der supraleitenden Magnetanordnung (1) räumlich so angeordnet und elektrisch derart miteinander verschaltet sind, dass sie gemeinsam eine magnetfelderzeugende Spule bilden.

10. Kryostatanordnung nach einem der vorhergehenden Ansprüche, **dadurch gekennzeichnet, dass** die Wärmesenke-Einrichtung, insbesondere eine Magnetspule (2) in der Wärmesenke-Einrichtung, von einer magnetischen Abschirmung umgeben ist.

11. Kryostatanordnung nach Anspruch 10, **dadurch gekennzeichnet, dass** die. magnetische Abschirmung der Wärmesenke-Einrichtung eine aktive Abschirm-Magnetspule umfasst.

12. Kryostatanordnung nach Anspruch 10, **dadurch gekennzeichnet, dass** die. magnetische Abschirmung der Wärmesenke-Einrichtung eine passive Magnetschildanordnung, insbesondere aus supraleitendem Material, aus Weicheisen oder aus einer in sich kurzgeschlossenen Spule aus supraleitendem Draht, umfasst.

13. Kryostatanordnung nach einem der vorhergehenden Ansprüche, **dadurch gekennzeichnet, dass** die supraleitende Magnetanordnung (1) HTS-Elemente umfasst.

14. Kryostatanordnung nach einem der vorhergehenden Ansprüche, **dadurch gekennzeichnet, dass** die Kryostatanordnung Teil einer Magnetresonanz-Apparatur ist.

15. Kryostatanordnung nach einem der vorhergehenden Ansprüche, **dadurch gekennzeichnet, dass** das magnetokalorische Material (3) der Wärmesenke-Einrichtung GGG (Gadolinium Gallium Garnet), DGG (=Dysprosium Gallium Garnet), GLF (=Gallium Lithium Fluorid") oder DAG (=Dysprosium Aluminium Garnet) enthält.

**Claims**

1. A cryostat arrangement comprising a cryocooler (4) that keeps the cryostat arrangement at a cryogenic operating temperature in a dry manner, i.e. without providing or supplying cryogenic fluids, at least one superconducting magnet arrangement (1) and a heat sink apparatus being present in the cryostat arrangement, wherein the heat sink apparatus prolongs the time before the superconducting magnet arrangement (1) returns to the normally conducting state (= "time to quench") if active cooling of the cryocooler (4) fails during operation, **characterized in that** the heat sink apparatus contains magnetocaloric material (3), and **in that** the heat sink apparatus is connected in a thermally conductive manner to the superconducting magnet arrangement (1) and/or to parts of the cryostat arrangement, through which ambient heat can flow to the magnet arrangement (1).

2. The cryostat arrangement according to claim 1, **characterized in that** the parts of the cryostat arrangement, through which ambient heat can flow to the magnet arrangement (1), include parts of the cryocooler (4) positioned within the cryostat arrangement and/or other parts of the cryostat arrangement, namely radiation shields and/or mechanical suspension devices (5) for the magnet arrangement (1) and/or electric supply lines to the magnet arrangement (1).

3. The cryostat arrangement according to either claim 1 or claim 2, **characterized in that** the heat sink apparatus in the cryostat arrangement is arranged relative to the superconducting magnet arrangement (1) such that the magnetocaloric material (3) can be made as free of magnetic fields as possible such that the magnetocaloric material is in a field of <2 Tesla at the end of the demagnetization process.

4. The cryostat arrangement according to any of the preceding claims, **characterized in that** a device for keeping the temperature of the magnetocaloric material (3) constant during normal operation is provided and comprises in particular a thermometer, a heating apparatus and an electronic heat control unit for the heat sink apparatus.

5. The cryostat arrangement according to any of the preceding claims, **characterized in that** the heat sink apparatus has at least one - optionally more than one - magnetic coil (2).

6. The cryostat arrangement according to claim 5, **characterized in that** the magnet coil (2) of the heat sink apparatus is superconductingly short-circuited when in operation.

7. The cryostat arrangement according to either claim 5 or claim 6, **characterized in that** the magnet coil (2) of the heat sink apparatus is electrically connected to a coil of the superconducting magnet arrangement (1).

8. The cryostat arrangement according to claim 7, **characterized in that** the magnet coil (2) of the heat sink apparatus is electrically connected in series to a coil of the superconducting magnet arrangement (1).

9. The cryostat arrangement according to claim 8, **characterized in that** the magnet coil (2) of the heat sink apparatus and the coil of the superconducting magnet arrangement (1) are spatially arranged and electrically interconnected in such a way that together they form a magnetic field-generating coil.

10. The cryostat arrangement according to any of the preceding claims, **characterized in that** the heat sink apparatus, in particular a magnet coil (2) in the heat sink apparatus, is surrounded by a magnetic shield.

11. The cryostat arrangement according to claim 10, **characterized in that** the magnetic shielding of the heat sink apparatus includes an active shield magnet coil.

12. The cryostat arrangement according to claim 10, **characterized in that** the magnetic shielding of the heat sink apparatus has a passive magnet shield arrangement, in particular one consisting of superconducting material, soft iron or a coil made of superconducting wire which is short-circuited in itself.

13. The cryostat arrangement according to any of the preceding claims, **characterized in that** the superconducting magnet arrangement (1) comprises HTS elements.

14. The cryostat arrangement according to any of the preceding claims, **characterized in that** the cryostat arrangement is part of a piece of magnetic resonance equipment.

15. The cryostat arrangement according to any of the preceding claims, **characterized in that** the magnetocaloric material (3) of the heat sink apparatus contains GGG (=gadolinium gallium garnet), DGG (=dysprosium gallium garnet), GLF (=gallium lithium fluoride) or DAG (=dysprosium aluminum garnet).

**Revendications**

1. Dispositif cryostatique comprenant un refroidisseur cryogénique (4) au moyen duquel ledit dispositif cryostatique peut être maintenu à une température de service cryogénique à l'état sec, c'est-à-dire en l'absence de fourniture ou de délivrance de fluides cryogènes, au moins un ensemble magnétique supraconducteur (1), ainsi qu'un appareil de réduction de chaleur, étant présents dans ledit dispositif cryostatique, sachant que, lors d'une défaillance du refroidissement actif du refroidisseur cryogénique (4), ledit appareil de réduction de chaleur prolonge, en service, le temps s'écoulant jusqu'à ce que ledit ensemble magnétique supraconducteur (1) retourne à l'état de conduction normale (= « time-to-quench »), **caractérisé par le fait que** l'appareil de réduction de chaleur renferme un matériau magnétocalorique (3) ; et par le fait que ledit appareil de réduction de chaleur est en liaison thermoconductrice avec l'ensemble magnétique supraconducteur (1) et/ou avec des parties dudit dispositif cryostatique par l'intermédiaire desquelles de la chaleur ambiante peut affluer sur ledit ensemble magnétique (1).

2. Dispositif cryostatique selon la revendication 1, **caractérisé par le fait que** les parties dudit dispositif cryostatique, par l'intermédiaire desquelles de la chaleur ambiante peut affluer sur l'ensemble magnétique (1), incluent des parties du refroidisseur cryogénique (4) logées à l'intérieur dudit dispositif cryostatique et/ou d'autres parties dudit dispositif cryostatique, à savoir des écrans antirayonnement et/ou des appareils (5) de suspension mécanique dédiés audit ensemble magnétique (1), et/ou des conducteurs électriques gagnant ledit ensemble magnétique (1).

3. Dispositif cryostatique selon la revendication 1 ou 2, **caractérisé par le fait que** l'appareil de réduction de chaleur est agencé dans ledit dispositif cryostatique, par rapport à l'ensemble magnétique supraconducteur (1), de façon telle que le matériau magnétocalorique (3) puisse être rendu le plus possible exempt de champ magnétique, de telle sorte que ledit matériau magnétocalorique se situe dans une plage < 2 teslas à la fin du processus de démagnétisation.

4. Dispositif cryostatique selon l'une des revendications précédentes, **caractérisé par** la présence d'un appareil qui est conçu pour maintenir constante la température du matériau magnétocalorique (3) en service normal, et inclut notamment un thermomètre, un appareil de chauffage et une unité électronique de régulation de chaleur, affectée à l'appareil de réduction de chaleur.

5. Dispositif cryostatique selon l'une des revendications précédentes, **caractérisé par le fait que** l'appareil de réduction de chaleur inclut au moins une bobine magnétique (2) - additionnelle, le cas échéant -.

6. Dispositif cryostatique selon la revendication 5, **caractérisé par le fait que** la bobine magnétique (2) de l'appareil de réduction de chaleur est court-circuitée en mode supraconducteur à l'état de fonctionnement.

7. Dispositif cryostatique selon la revendication 5 ou 6, **caractérisé par le fait que** la bobine magnétique (2) de l'appareil de réduction de chaleur est raccordée électriquement à une bobine de l'ensemble magnétique supraconducteur (1).

8. Dispositif cryostatique selon la revendication 7, **caractérisé par le fait que** la bobine magnétique (2) de l'appareil de réduction de chaleur est branchée électriquement en série avec une bobine de l'ensemble magnétique supraconducteur (1).

9. Dispositif cryostatique selon la revendication 8, **caractérisé par le fait que** la bobine magnétique (2) de l'appareil de réduction de chaleur et la bobine de l'ensemble magnétique supraconducteur (1) sont agencées dans l'espace, et connectées électriquement l'une à l'autre, de façon telle qu'elles forment associativement une bobine génératrice de champs magnétiques.

10. Dispositif cryostatique selon l'une des revendications précédentes, **caractérisé par le fait que** l'appareil de réduction de chaleur, en particulier une bobine magnétique (2) intégrée dans ledit appareil de réduction de chaleur, sont entourés par un blindage magnétique.

**11.** Dispositif cryostatique selon la revendication 10, **caractérisé par le fait que** le blindage magnétique de l'appareil de réduction de chaleur inclut une bobine de blindage magnétique actif.

**12.** Dispositif cryostatique selon la revendication 10, **caractérisé par le fait que** le blindage magnétique de l'appareil de réduction de chaleur inclut un ensemble d'écrans magnétiques passifs consistant, notamment, en un matériau supraconducteur, en du fer doux ou en une bobine de fil métallique supraconducteur intrinsèquement court-circuitée.

**13.** Dispositif cryostatique selon l'une des revendications précédentes, **caractérisé par le fait que** l'ensemble magnétique supraconducteur (1) inclut des éléments HTS.

**14.** Dispositif cryostatique selon l'une des revendications précédentes, **caractérisé par le fait que** ledit dispositif cryostatique fait partie d'un appareillage à résonance magnétique.

**15.** Dispositif cryostatique selon l'une des revendications précédentes, **caractérisé par le fait que** le matériau magnétocalorique (3) de l'appareil de réduction de chaleur renferme du GGG (grenat de gadolinium-gallium), du DGG (=grenat de dysprosium-gallium), du GLF (=fluorure de gallium-lithium) ou du DAG (=grenat de dysprosium-aluminium).

**Fig. 1**

Fig. 2a

Fig. 2b

# PRIOR ART

**Fig. 3a**

The specific heat of $(Er_{0.53}Ho_{0.47})$ $Co_2$ [76].

**Fig. 3b**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0937953 A1
- DE 19914778 B4

- DE 102014218773 A1

**In der Beschreibung aufgeführte Nicht-Patentliteratur**

- **ZHU Y ; ASAMOTO K ; NISHIMURA Y ; KOUEN T ; ABE S ; MATSUMOTO K et al.** *Cryogenics,* 2011, vol. 51, 494